# EUROPEAN PATENT APPLICATION

(11) **EP 2 120 337 A1**
(43) Date of publication of application: **18.11.2009**
(21) Application number: 09004272.2
(22) Date of filing: 25.03.2009
(51) Int. Cl.: H03J 3/26

(54) **Voltage controlled oscillator including inter-terminal connection and trap circuit**

(30) Priority: 12.05.2008 JP 2008124546
(71) Applicant: Alps Electric Co., Ltd., Tokyo 145-8501 (JP)
(72) Inventor: Nakatsuka, Kenji, Tokyo, 145-8501 (JP)
(74) Representative: Schraud, Robert Alexander

(57) **Abstract**

A voltage controlled oscillator includes: a voltage controlled oscillation circuit (1), an oscillation frequency thereof being controlled by a control voltage signal; a PLL circuit (2) that generates a control voltage signal to be input to the voltage controlled oscillation circuit (1); a multiplier circuit (3) that multiplies an oscillation signal output from the voltage controlled oscillation circuit (1); and a band-pass filter and trap circuit (4) that sets a pass band for passing a signal with a predetermined multiplication number of multiplication signals output from the multiplier circuit (3) and a trap frequency equal to the frequency of the oscillation signal input to the multiplier circuit (3), and varies the pass band and the trap frequency in synchronization with the control voltage signal.

## Description

### Cross Reference to Related Applications

The present application contains subject matter related to Japanese Patent Application No. 2008-124546 filed in the Japanese Patent Office on May 12, 2008, the entire contents of which being incorporated herein by reference.

### BACKGROUND

### 1. Technical Field

The present invention relates a voltage controlled oscillator to obtain an oscillation signal with a desired frequency by multiplying an oscillation signal.

### 2. Related Art

In the field of mobile radio communication, an oscillation signal generated by a local oscillator is input to a mixer to perform frequency conversion. Recently, a local oscillator with a high frequency and a wide variable width is demanded. In the related art, a voltage controlled oscillator has been known, in which an output of the voltage controlled oscillator is multiplied to widen a variable width of the voltage controlled oscillator, and then a multiplication signal with a desired frequency is taken out through a band-pass filter.

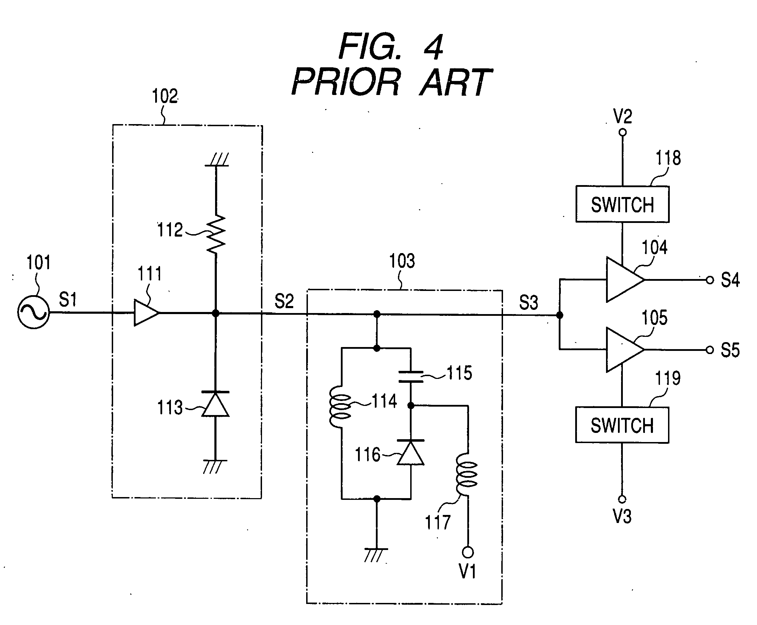

Fig. 4 is a circuit diagram illustrating a voltage controlled oscillator described in Japanese Patent Application Lain-Open No. 6-164445. A source oscillation signal S1 with a frequency f0 is output from a VCO 101, and a high frequency signal S2 obtained by multiplying a frequency f of the source oscillation signal S1 into 2f, 3f, 4f, ... by a multiplier 102 is output. The multiplier 102 includes an amplifier 111, a resistor 112 for magnetic bias connected between the output terminal of the amplifier 111 and the ground, and a step-recovery diode 113. The multiplication operation in the multiplier 102 is performed by the diode 113, and is not performed by variation of capacity with respect to a reverse voltage but is performed by rapid variation of capacity generated at the time when a high frequency voltage applied to the diode 113 is overdriven from a reverse direction to a forward direction. A high frequency signal S2 output from the multiplier 102 is input to a variable frequency band-pass filter 103. The variable frequency band-pass filter 103 is formed of an LC resonance circuit including a coil 114, a capacitor 115, and a varactor diode 116. A pass band of the variable frequency band-pass filter 103 is set by a control voltage V1 applied through a coil 117. For example, when the pass band is set to allow a signal with a frequency 3f to pass, a multiplication signal S3 with a frequency 3f output from the multiplier 102 passes through the variable frequency band-pass filter 103 and is input to an amplifiers 104 and 105. Signals with a frequency out of the set pass band are attenuated as unnecessary signals. The amplifiers 104 and 105 are controlled to be turned on or off by transistor switches (switches) 118 and 119 turned on or off according to control voltages V2 and V3, respectively.

As described above, it is possible to configure an oscillation circuit using components with a high Q value by employing the multiplication-type oscillation circuit, and it is possible to configure an oscillation circuit with high C/N and high stability in frequency.

In an oscillation circuit using a multiplier for obtaining a multiplication signal using non-linearity of input and output characteristics of transistors or the like, a large amount of 1/2 multiplication waves (source oscillation signals) and harmonics are generated. Accordingly, it is necessary to sufficiently remove unnecessary signals (e.g., in the example, 1/2 multiplication waves (source oscillation signals), 3f, 4f...) out of a desired pass band by enhancing a filter function on the RF output side. When a trap circuit for removing the 1/2 multiplication waves (source oscillation signals) and a band-pass circuit for attenuating harmonics of 3f, 4f, ... are combined with each other into a filter, it is difficult to perform impedance matching within a frequency variable range as the frequency variable width of the oscillator gets wider.

### SUMMARY

An advantage of some aspects of the invention is to provide a voltage controlled oscillator capable of securing high C/N and frequency stability by employing a multiplication-type oscillation circuit, capable of suppressing leakage of unnecessary signals out of band even when a frequency variable width is widened, and capable of easily performing impedance matching.

According to an aspect of the invention, a voltage controlled oscillator includes: a voltage controlled oscillation circuit, an oscillation frequency thereof being controlled by a control voltage signal; PLL circuit that generates a control voltage signal to be input to the voltage controlled oscillation circuit; a multiplier circuit that multiplies an oscillation signal output from the voltage controlled oscillation circuit; and band-pass filter and trap circuit that sets a pass band for passing a signal with a predetermined multiplication number of multiplication signals output from the multiplier circuit and a trap frequency equal to the frequency of the oscillation signal input to the multiplier circuit, and varies the pass band and the trap frequency in synchronization with the control voltage signal.

With such a configuration, since the multiplication signal obtained by multiplying the oscillation signal output from the voltage controlled oscillation circuit is output as an oscillation signal, it is possible to secure high C/N and frequency stability. Since the frequency equal to that of the oscillation signal input to the multiplier circuit is trapped, it is possible to suppress leakage of the source oscillation signal. In addition, it is possible to vary the pass band and the trap frequency in synchronization with the control voltage signal for determining the oscillation frequency of the voltage controlled oscillation circuit.

In the voltage controlled oscillator, it is preferable that a control voltage signal output terminal of the PLL circuit is connected to a control voltage signal input terminal of the voltage controlled oscillation circuit and a control voltage signal input terminal of the band-pass filter and trap circuit.

With such a configuration, since the control voltage signal output from the PLL circuit is divided and is parallel applied to the voltage control oscillation circuit and the band-pass filter and trap circuit, it is possible to simply configure the voltage controlled oscillator in synchronization with the control voltage signal.

In the voltage controlled oscillator, it is preferable that the band-pass filter and trap circuit includes: an input terminal to which an output signal of the multiplier circuit is input; an output terminal from which a signal passing through the pass band is output; a first parallel resonance circuit that has one end connected to the input terminal of the band-pass filter and trap circuit and the other end connected to the ground and synchronizes parallel in the pass band; a second parallel resonance circuit that has one end connected to the output terminal of the band-pass filter and trap circuit and the other end connected to the ground and synchronizes parallel in the pass band; a third parallel resonance circuit that has one end connected to the input terminal of the band-pass filter and trap circuit and the other end connected to the output terminal of the band-pass filter and trap circuit to connect a terminal of the first parallel resonance circuit and a terminal of the second parallel resonance circuit to each other, and synchronizes parallel at the trap frequency; and an inductor that is serially connected to the third parallel resonance circuit, and a degree of the inter-terminal connection is controlled by the control voltage signal, and impedance matching is performed by the third parallel resonance circuit and the inductor.

With such a configuration, the trap circuit is configured by the third parallel resonance circuit for the inter-terminal connection between the first parallel resonance circuit and the second parallel resonance circuit, and the degree of the inter-terminal connection and the trap frequency are automatically controlled in accordance with a voltage value of the control voltage signal for determining the oscillation frequency. Accordingly, it is possible to vary the pass band and the trap frequency at the same time, and to correct the impedance matching at the same time in accordance with the oscillation frequency.

In the voltage controlled oscillator, it is preferable that each of the first, second, and third parallel resonance circuits includes a varactor diode, an anode of which is connected to the output terminal of the PLL circuit.

With such a configuration, it is possible to shift the pass band and the trap frequency in association with each other in synchronization with the oscillation frequency with a simple configuration.

According to the invention, it is possible to secure high C/N and frequency stability by employing the multiplication-type oscillation circuit, it is possible to suppress leakage of unnecessary signals out of band even when a frequency variable width is widened, and it is possible to correct the impedance matching at the same time.

### BRIEF DESCRIPTION OF THE DRAWINGS

Fig. 1 is a functional block diagram illustrating a voltage controlled oscillator according to an embodiment of the invention.
Fig. 2 is a circuit diagram illustrating a band-pass filter and trap circuit for the voltage controlled oscillator according to the embodiment.
Fig. 3A is a diagram illustrating a simulation result of a pass band and a trap frequency in case of a control voltage signal Vct1=Lo.
Fig. 3B is a diagram illustrating a simulation result of a pass band and a trap frequency in case of a control voltage signal Vct1=Hi.
Fig. 4 is a diagram illustrating a configuration of the known voltage controlled oscillator.

### DESCRIPTION OF EXEMPLARY EMBODIMENTS

An embodiment of the invention will be described hereinafter with reference to the accompanying drawings.

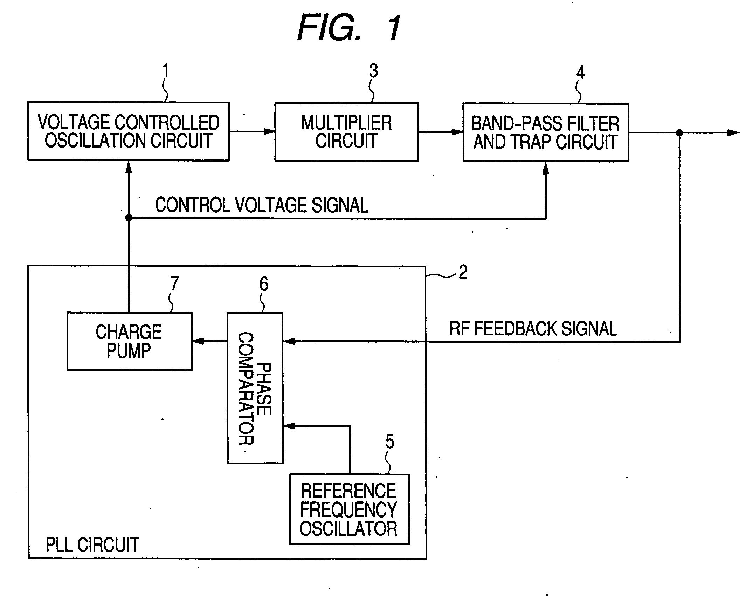

Fig. 1 is a functional block diagram illustrating a voltage controlled oscillator according to an embodiment of the invention. The voltage controlled oscillator according to the embodiment mainly includes a voltage controlled oscillation circuit 1, a PLL circuit 2 that controls an oscillation frequency of the voltage controlled oscillation circuit 1 to be a predetermined frequency, a multiplier circuit 3 that multiplies an oscillation signal output from the voltage controlled oscillation circuit 1, and a band-pass filter and trap circuit 4, to which signals (multiplication output signal and source oscillation signal) output from the multiplier circuit 3 are input, and which varies a trap frequency and a pass band in synchronization with a control voltage signal.

The voltage controlled oscillation circuit 1 is configured to control a frequency of the oscillation signal by the control voltage signal input from the PLL circuit 2. In the PLL circuit 2, a reference frequency generated by a reference frequency oscillator 5 formed of a crystal oscillator is compared with a phase of an RF feedback signal obtained by feeding back the output signal of the voltage controlled oscillator by a phase comparator 6. A charge pump 7 is charged with a phase difference signal output from the phase comparator 6 so that a control voltage signal corresponding to the phase difference between the reference frequency and the RF feedback signal is output from the charge pump 7. In the phase comparator 6, the RF feed back signal and the reference frequency may be separately divided by a frequency divider (not shown), and phases thereof may be compared in a low frequency state with each other. The multiplier circuit 3 is configured to output a frequency signal (i.e., multiplication output signal) that is an integer times the frequency of the input signal, using non-linearity of input and output characteristics of transistors or the like.

In the output signal of the voltage controlled oscillator, it is necessary to increase electric power of the multiplication signal and to decrease electric power of unnecessary signals. The unnecessary signals are lower-degree and higher-degree signals other than a desired multiplication output signal, among the output signals output from an amplifier such as a transistor constituting the multiplier circuit 3. Among the unnecessary signals, an output signal with the same frequency as that of the input signal is a source oscillation signal. There are many cases that the output power of the source oscillation signal is larger than that of the multiplication signal. For this reason, the band-pass filter and trap circuit 4 is formed of a filter obtained by combining a band-pass filter, in which a desired band of the multiplication signal is set as a pass band, with a trap filter set to trap the source oscillation signal.

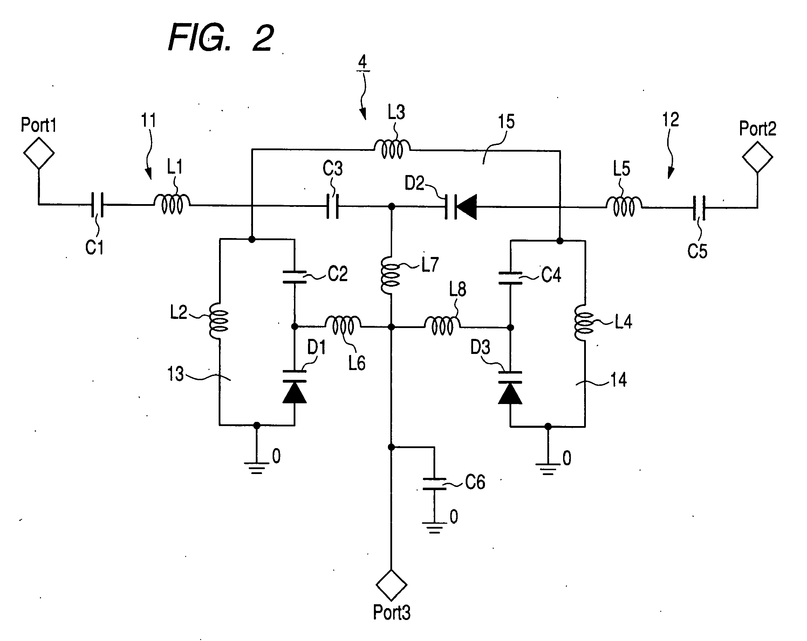

Fig. 2 is a circuit diagram illustrating the band-pass filter and trap circuit 4.

An output signal of the multiplier circuit 3 is input to an input terminal Port 1 of the band-pass filter and trap circuit 4, and an oscillation signal with a predetermined frequency is output from an output terminal Port 2 of the band-pass filter and trap circuit 4. In the embodiment, a control voltage signal Vct1 output from the PLL circuit 2 is applied to the voltage controlled oscillation circuit 1 and to a frequency variable terminal Port 3.

The band-pass filter and trap circuit 4 has an input matching circuit 11 for matching with an external circuit connected to the input terminal Port 1, and an output matching circuit 12 for matching with an external circuit connected to the output terminal Port 2. The matching circuit 11 is formed of a serial circuit including a capacitor C1, one end of which is connected to the input terminal Port 1, and an inductor L1, one end of which is connected to the other end of the capacitor C1. The matching circuit 12 is formed of a serial circuit including an inductor L5, one end of which is connected to a resonance circuit, and a capacitor C5, one end of which is connected to the other end of the inductor L5 and the other end of which is connected to the output terminal Port 2. The impedance matching may be performed using any one inductor of the inductors L1 and L5.

Frequency variable first and second resonance circuits 13 and 14 are connected between the input matching circuit 11 and the output matching circuit 12. An inter-terminal connection and trap circuit 15 for inter-terminal connecting between the first and second resonance circuits 13 and 14 to each other and trapping the source oscillation signal is provided between the first resonance circuit 13 and the second resonance circuit 14. The first resonance circuit 13 constitutes a first parallel resonance circuit, and the second resonance circuit 14 constitutes a second parallel resonance circuit. The inter-terminal connection and trap circuit 15 constitutes a third parallel resonance circuit.

An inductor L2 of the first resonance circuit 13 is serially connected between the end of the inductor L1 and the ground, and a serial circuit including a capacitor C2 and a varactor diode D1 is connected parallel to the inductor L2, thereby forming an LC parallel resonance circuit. An inductor L4 of the second resonance circuit 14 is serially connected between the end of the inductor L5 and the ground, and a serial circuit including a capacitor C4 and a varactor diode D3 is connected parallel to the inductor L4, thereby forming an LC parallel resonance circuit. The inter-terminal connection and trap circuit 15 includes a capacitor C3, one end of which is connected to the end of the inductor L1 of the first resonance circuit 13, a varactor diode D2, a cathode of which is connected to the other end of the capacitor C3, and an inductor L3 connected between the end of the capacitor C3 close to the matching circuit 11 and an anode of the varactor diode D2.

In the embodiment, a synchronization frequency is set so that the first and second resonance circuits 13 and 14 synchronize with a second-order harmonic of the voltage controlled oscillation circuit 1, and the inter-terminal connection and trap circuit 15 varies the trap frequency into the frequency of the source oscillation signal of the voltage controlled oscillation circuit 1. In the embodiment, a 1/2 frequency of the pass band of the first and second resonance circuits 13 and 14 is the trap frequency of the inter-terminal connection and trap circuit 15.

The pass band of the first and second resonance circuits 13 and 14 is varied in synchronization with the second-order harmonic of the voltage controlled oscillation circuit 1, and the trap frequency of the inter-terminal connection and trap circuit 15 is varied according to the source oscillation signal of the voltage controlled oscillation circuit 1. For this reason, the cathode of the varactor diode D1 in the first resonance circuit 13 is connected to the frequency variable terminal Port 3 through a choke inductor L6, and the cathode of the varactor diode D3 in the second resonance circuit 14 is connected to the frequency variable terminal Port 3 through a choke inductor L8. The cathode of the varactor diode D2 in the inter-terminal connection and trap circuit 15 is connected to the frequency variable terminal Port 3 through a choke inductor L7. The frequency variable terminal Port 3 is connected to the ground at high frequency through a bypass capacitor C6.

Next, an operation of the embodiment configured as described above will be described.

In the voltage controlled oscillator according to the embodiment, the oscillation frequency of the voltage controlled oscillation circuit 1 is in the range of 950 to 1050 MHz, and the frequency of the oscillation signal output to the outside is in the range of 1.9 to 2.1 GHz. The pass band of the first and second resonance circuits 13 and 14 is in the range of 1.9 to 2.1 GHz, and the trap frequency of the inter-terminal connection and trap circuit 15 is in the range of 950 to 1050 MHz.

In the PLL circuit 2, the reference frequency signal generated from the reference frequency oscillator 5 is input to the phase comparator 6, and the output signal of the voltage controlled oscillator is input as the RF feedback signal. A phase difference signal based on a phase difference between the reference frequency signal and the RF feedback signal is input to the charge pump 7, and a control voltage signal Vct1 corresponding to the phase difference is generated. The control voltage signal Vct1 is controlled so that the output signal of the voltage controlled oscillator is kept in a predetermined frequency.

The control voltage signal Vct1 output from the PLL circuit 2 is input to the voltage controlled oscillation circuit 1 and is divided to be input to the band-pass filter and trap circuit 4. In the voltage controlled oscillation circuit 1, the oscillation frequency is controlled by the control voltage signal Vct1. For example, it is assumed that the frequency variable width is in the range of 950 to 1050 MHz. When the minimum control voltage signal Vct1 is Lo, the oscillation frequency of 950 MHz is output. When the maximum control voltage signal Vct1 is Hi, the maximum oscillation frequency of 1050 MHz is output.

In the multiplier circuit 3, the oscillation signal output from the voltage controlled oscillation circuit 1 is converted into an integer times frequency signal using non-linearity of the input and output characteristics of an amplifier (not shown) (transistor, etc.). For example, when the frequency of the output signal of the voltage control oscillation circuit 1 is 950 MHz, the source oscillation signal with the same frequency (950 MHz) as that of the output signal of the voltage control oscillation circuit 1, the second-order harmonic (1.9 GHz), third -order, fourth-order... harmonics are generated.

In the band-pass filter and trap circuit 4, the pass band and the trap frequency are controlled by the control voltage signal Vct1. In the first resonance circuit 13, the control voltage signal Vct1 is applied to the cathode of the varactor diode D1 through the choke inductor L6. The capacity of the varactor diode D1 is varied according to the value of the control voltage signal Vct1, thereby varying the synchronization frequency of the first resonance circuit 13. In this case, when the control voltage signal Vct1 is Lo, the resonance frequency is 1.9 GHz. When the control voltage signal Vct1 is Hi, the resonance frequency is 2.1 GHz. In the second resonance circuit 14, the control voltage signal Vct1 is applied to the cathode of the varactor diode D3 through the choke inductor L8. Similarly with the first resonance circuit 13, when the control voltage signal Vct1 is Lo, the resonance frequency is 1.9 GHz. When the control voltage signal Vct1 is Hi, the resonance frequency is 2.1 GHz. The band-pass filter having the pass band of the band-pass filter and trap circuit 4 is configured by the first and second resonance circuits 13 and 14. For example, when the control voltage signal Vct1 is Lo, the pass band is set to 1.9 GHz and the second-order harmonic (1.9 GHz) output from the multiplier circuit 3 is selected and output from the output terminal Port 2. When the control voltage signal Vct1 is Hi, the pass band is set to 2.1 GHz and the second-order harmonic (2.1 GHz) output from the multiplier circuit 3 is selected and output from the output terminal Port 2.

The first resonance circuit 13 and the second resonance circuit 14 are connected to each other by the inter-terminal connection and trap circuit 15. The degree of the inter-terminal connection is controlled by the control voltage signal Vct1 applied to the cathode of the varactor diode D2 of the inter-terminal connection and trap circuit 15, and the trap frequency is varied. As described above, the pass band is varied from 1.9 GHz to 2.1 GHz as the control voltage signal Vct1 is raised from Lo to Hi. In the inter-terminal connection and trap circuit 15, the degree of the inter-terminal connection is decreased and the trap frequency is raised as the control voltage signal Vct1 applied to the cathode of the varactor diode D2 is raised from Lo to Hi. That is, the degree of the inter-terminal connection is varied to correct the impedance matching with the external circuit by the variation of the pass band of the first and second resonance circuits 13 and 14. Accordingly, it is possible to solve the problem that the impedance matching is difficult according to the variable width. In addition, the trap frequency is also varied by the variation of the pass band of the first and second resonance circuits 13 and 14. Accordingly, the source oscillation signal is variable to be constantly the trap frequency.

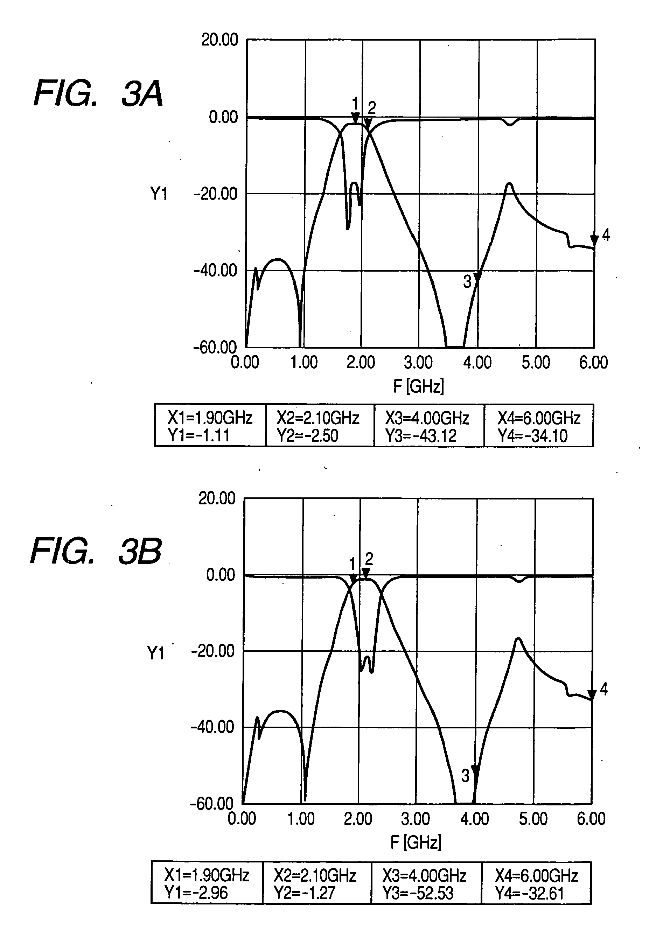

Fig. 3A and Fig. 3B are diagrams illustrating simulation results of the pass band and the trap frequency using the inter-terminal connection and trap circuit 15 having the circuit configuration of the band-pass filter and trap circuit 4. Fig. 3A is a simulation result in case of the control voltage signal Vct1=Lo, and Fig. 3B is a simulation result in case of the control voltage signal Vct1=Hi.

As shown in Fig. 3A, when the control voltage signal Vct1 is Lo, the second-order harmonic (1.9 GHz) with respect to the input signal (950 MHz) of the multiplier circuit 3 is a center frequency of the pass band, and sufficient attenuation is secure with respect to the harmonics of orders (third order, fourth order...) higher than the second order. As can be seen from Fig. 3A, 950 MHz that is the same frequency as the oscillation frequency (source oscillation signal) in the voltage controlled oscillation circuit 1 when the control voltage signal Vct1 is Lo is the trap frequency.

As shown in Fig. 3B, when the control voltage signal Vct1 is Hi, the second-order harmonic (2.1 GHz) with respect to the input signal (1050 MHz) of the multiplier circuit 3 is a center frequency of the pass band, and sufficient attenuation is secure with respect to the harmonics of orders (third order, fourth order...) higher than the second order. As can be seen from Fig. 3B, 1050 MHz that is the same frequency as the oscillation frequency (source oscillation signal) in the voltage controlled oscillation circuit 1 when the control voltage signal Vct1 is Hi is the trap frequency.

As can be seen from the simulation results, in the inter-terminal connection and trap circuit 15, the pass band is shifted to the band of the second-order harmonic of the multiplier circuit 2 in synchronization with the control voltage signal Vct1, and the trap frequency is shifted to the position of the first-order harmonic (source oscillation signal) of the multiplier circuit 2.

As described above, according to the embodiment, the control voltage signal Vct1 input from the PLL circuit 2 to the voltage controlled oscillation circuit 1 is divided and input to the inter-terminal connection and trap circuit 15, the pass band and the trap frequency of the inter-terminal connection and trap circuit 15 are varied in synchronization with the oscillation frequency. Accordingly, it is possible to configure the filter with an excellent attenuation characteristic within narrow band and out of band, it is possible to secure high C/N and frequency stability by employing the multiplication-type oscillation circuit, and thus it is possible to suppress leakage of unnecessary signals out of band even when the frequency variable width is widened. In addition, the degree of the inter-terminal connection of the inter-terminal connection and trap circuit 15 is varied according to the pass band using the control voltage signal Vct1. Accordingly, it is possible to easily perform the impedance matching, which is difficult when the variable width is widened.

The invention is not limited to the above-described embodiment, and may be variously modified within the technical scope of the invention. For example, the resonance circuit in the band-pass filter and trap circuit 4 may be configured in three or more stages, thereby obtaining the same effects.

The invention may be applied to a voltage control oscillator employing a multiplication-type oscillation circuit.

## Claims

1. A voltage controlled oscillator including an inter-terminal connection and trap circuit, the voltage controlled oscillator comprising:
a voltage controlled oscillation circuit, an oscillation frequency thereof being controlled by a control voltage signal;
a PLL circuit that generates a control voltage signal to be input to the voltage controlled oscillation circuit;
a multiplier circuit that multiplies an oscillation signal output from the voltage controlled oscillation circuit; and
a band-pass filter and trap circuit that sets a pass band for passing a signal with a predetermined multiplication number of multiplication signals output from the multiplier circuit and a trap frequency equal to the frequency of the oscillation signal input to the multiplier circuit, and varies the pass band and the trap frequency in synchronization with the control voltage signal.

2. The voltage controlled oscillator including the inter-terminal connection and trap circuit according to Claim 1, wherein a control voltage signal output terminal of the PLL circuit is connected to a control voltage signal input terminal of the voltage controlled oscillation circuit and a control voltage signal input terminal of the band-pass filter and trap circuit.

3. The voltage controlled oscillator including the inter-terminal connection and trap circuit according to Claim 1 or 2, wherein the band-pass filter and trap circuit includes:
an input terminal to which an output signal of the multiplier circuit is input;
an output terminal from which a signal passing through the pass band is output;
a first parallel resonance circuit that has one end connected to the input terminal of the band-pass filter and trap circuit and the other end connected to the ground and synchronizes parallel in the pass band;
a second parallel resonance circuit that has one end connected to the output terminal of the band-pass filter and trap circuit and the other end connected to the ground and synchronizes parallel in the pass band;
a third parallel resonance circuit that has one end connected to the input terminal of the band-pass filter and trap circuit and the other end connected to the output terminal of the band-pass filter and trap circuit to connect a terminal of the first parallel resonance circuit and a terminal of the second parallel resonance circuit to each other, and synchronizes parallel at the trap frequency; and
an inductor that is serially connected to the third parallel resonance circuit, and
wherein a degree of the inter-terminal connection is controlled by the control voltage signal, and impedance matching is performed by the third parallel resonance circuit and the inductor.

4. The voltage controlled oscillator including the inter-terminal connection and trap circuit according to Claim 1,2 or 3, wherein each of the first, second, and third parallel resonance circuits includes a varactor diode, an anode of which is connected to the output terminal of the PLL circuit.
